# EUROPÄISCHE PATENTSCHRIFT

(11) **EP 1 472 738 B1**
(45) Veröffentlichungstag und Bekanntmachung des Hinweises auf die Patenterteilung: **23.06.2010**
(21) Anmeldenummer: 03793593.9
(22) Anmeldetag: 08.08.2003
(51) Int. Cl.: H01L 27/115

(54) **BITLEITUNGSSTRUKTUR SOWIE VERFAHREN ZU DEREN HERSTELLUNG**
BITLINE STRUCTURE AND METHOD FOR PRODUCTION THEREOF
STRUCTURE DE LIGNES DE BITS ET PROCEDE DE PRODUCTION DE LADITE STRUCTURE

(30) Priorität: 02.09.2002 DE 10240436
(43) Veröffentlichungstag der Anmeldung: 03.11.2004
(73) Patentinhaber: Infineon Technologies AG, 85579 Neubiberg (DE)
(72) Erfinder: KAKOSCHKE, Ronald, 81475 München (DE); SHUM, Danny, Poughkeepsie, NY 12601 (US); TEMPEL, Georg, B-1933 Sterrebeek (BE)
(74) Vertreter: Karl, Frank
(86) Internationale Anmeldenummer: PCT/DE2003/002676
(87) Internationale Veröffentlichungsnummer: WO 2004/023553

(56) Entgegenhaltungen:
- WO-A-01/99152
- US-A- 5 796 167
- US-B1- 6 348 374

## Beschreibung

Die vorliegende Erfindung bezieht sich auf eine Bitleitungsstruktur sowie ein Verfahren zu deren Herstellung und insbesondere auf eine sub-100nm-Bitleitungsstruktur sowie ein zugehöriges Herstellungsverfahren wie es in einer nichtflüchtigen SNOR-Speicherschaltung zur jeweiligen selektiven Ansteuerung von Source- und Drainleitungen verwendet werden kann.

Bei der Realisierung von Speicherschaltungen unterscheidet man grundsätzlich die Speicherarchitektur, wobei die sogenannten NAND- und NOR-Architekturen am häufigsten vertreten sind. In beiden Architekturen werden beispielsweise sogenannte Eintransistor-Speicherzellen matrixförmig angeordnet und über sogenannte Wort- und Bitleitungen angesteuert.

Während in NAND-Architekturen eine Vielzahl von Schaltelementen bzw. Speicherelementen seriell miteinander verbunden sind und über ein gemeinsames Auswahlgatter bzw. einen Auswahltransistor angesteuert werden, sind die jeweiligen Schaltelemente in NOR-Architekturen parallel bzw. matrixförmig organisiert, wodurch jedes Schaltelement einzeln ausgewählt werden kann.

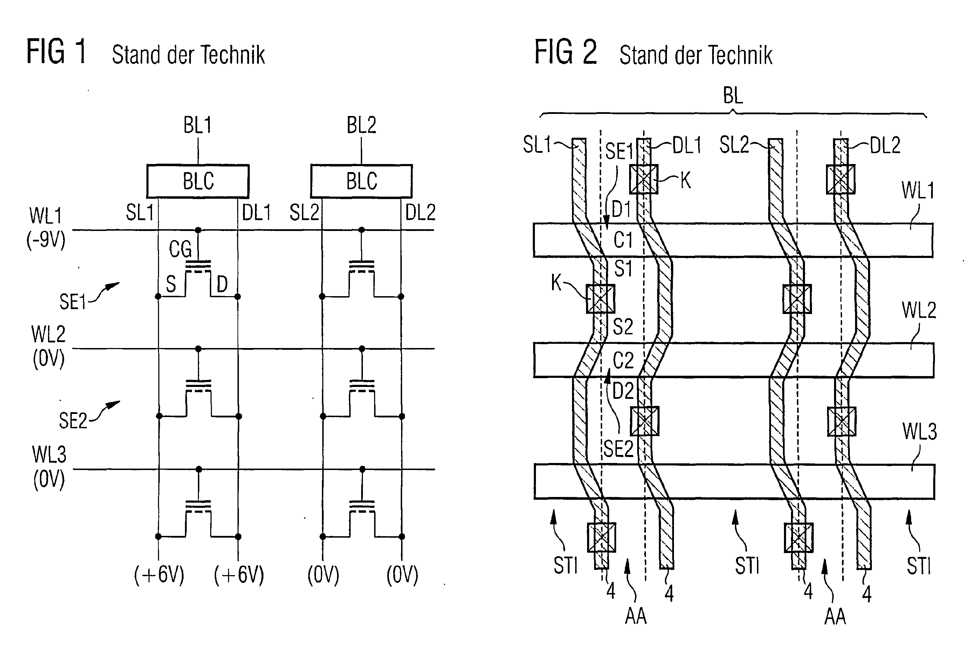

Figur 1 zeigt eine vereinfachte Darstellung einer sogenannten SNOR-Architektur (Selective NOR), bei der im Gegensatz zur NOR-Architektur mit "common source"-Aufbau die einzelnen Schaltelemente SE1, SE2, ... selektiv über eine jeweilige Sourceleitung SL1, SL2, ... und über eine jeweilige Drainleitung DL1, DL2, ... angesteuert werden. Diese selektive Ansteuerung wird beispielsweise über jeweilige Bitleitungssteuerungen BLC durchgeführt, welche sozusagen die gemeinsamen Bitleitungen BL1, BL2, ... realisieren. Auf diese Weise können weitere Shrinks bzw. eine weitergehende Integration von Halbleiterschaltungsanordnungen durchgeführt werden, da die SNOR-Architektur nicht auf eine vorbestimmte Mindest-Zelltransistorlänge bzw. Kanallänge angewiesen ist.

Figur 2 zeigt eine vereinfachte Darstellung eines herkömmlichen Layouts der SNOR-Architektur gemäß Figur 1. Gemäß Figur 2 werden die Schaltelemente bzw. Speicherelemente SE1, SE2, ... in aktiven Bereichen AA eines Halbleitersubstrats ausgebildet, die eine im Wesentlichen gerade streifenförmige Struktur aufweisen. Die Vielzahl von spaltenweise angeordneten streifenförmigen aktiven Bereichen AA werden zeilenweise von ebenfalls streifenförmig ausgebildeten Schichtstapeln bzw. Wortleitungsstapeln WL1, WL2, ... überlagert. Jeder Kreuzungspunkt bzw. Überlappungsbereich eines derartigen streifenförmigen aktiven Bereiches AA mit einem streifenförmig ausgebildeten Wortleitungsstapel WL1 bis WL3 stellt somit eine Vielzahl von Schaltelementen bzw. Speicherelementen SE dar.

Zum Kontaktieren von jeweiligen Draingebieten D und Sourcegebieten S sind Kontakte notwendig, die üblicherweise in den aktiven Bereichen AA ausgebildet sind, oftmals jedoch auch in ein angrenzendes Isolationsgebiet STI (Shallow Trench Isolation) reichen können. In einer weiteren darüberliegenden Schicht, die vorzugsweise eine erste Metallisierungsschicht darstellt, befinden sich nunmehr die Sourceleitungen SL1, SL2, ... sowie die Drainleitungen DL1, DL2, ... für die jeweiligen Bitleitungen BL. Die Drainleitungen stehen hierbei über entsprechende Kontakte K mit den dazugehörigen Draingebieten D des aktiven Bereichs AA in Verbindung, wobei in gleicher Weise die Sourceleitungen über entsprechende Kontakte mit den dazugehörigen Sourcegebieten S in Verbindung stehen.

Nachteilig ist jedoch bei einer derartigen herkömmlichen Bitleitungsstruktur, dass aufgrund der zusätzlichen Sourceleitungen im Vergleich zu einer common source-Architektur eine mehr als doppelt so dichte Metallisierung vorliegt, was einen begrenzenden Faktor für eine weitergehende Integration bzw. weitere Shrinks darstellt.

Zur Verbesserung einer Integrationsdichte wurde daher gemäß Druckschrift DE 100 62 245 A1 vorgeschlagen, die Source- und Drainleitungen als Spacer an einem isolierenden Steg auszubilden und über eine zusätzliche Isolierschicht mit entsprechenden Öffnungen eine Kontaktierung der zugehörigen Source-und Draingebiete zu ermöglichen. Weiterhin ist jedoch der Platzbedarf aufgrund der an der Substratoberfläche ausgebildeten und parallel liegenden Source- und Drainleitungen relativ hoch und verhindert eine weitergehende Integration.

Aus der Druckschrift US 6,008,522 ist ferner eine vergrabene Bitleitung bekannt, die in einem Isolationsgraben ausgebildet ist und über eine Anschlussschicht jeweilige Source- und Draingebiete symmetrisch kontaktiert.

Die den Oberbegriff der unabhängigen Patentansprüche bildende Druckschrift WO 01/99152 A offenbart eine Bitleitungsstruktur sowie ein zugehöriges Herstellungsverfahren, welches eine vergrabene Bitleitung aufweist, wobei die vergrabene Bitleitung in einem unteren Bereich eines isolierten Grabens, eine Abdeckisolationsschicht auf der vergrabenen Bitleitung in einem ersten oberen Teilbereich und eine Vielzahl von Abdeck-Verbindungsschichten auf der vergrabenen Bitleitung in einem zweiten oberen Teilbereich des Grabens ausgebildet sind. Die Abdeck-Verbindungsschichten sind ferner über Anschlussschichten mit einer Vielzahl von Dotiergebieten elektrisch verbunden.

Der Erfindung liegt daher die Aufgabe zugrunde, eine Bitleitungsstruktur sowie ein zugehöriges Herstellungsverfahren zu schaffen, wodurch sich insbesondere in SNOR-Architekturen eine weitergehende Integration bei verringertem Platzbedarf realisieren lässt.

Erfindungsgemäß wird diese Aufgabe hinsichtlich der Bitleitungsstruktur durch die Merkmale des Patentanspruchs 1 und hinsichtlich des Verfahrens durch die Maßnahmen des Patentanspruchs 8 gelöst.

Insbesondere durch die Kombination der vergrabenen Bitleitung mit einer Oberflächenbitleitung, die zum Anschließen einer Vielzahl von ersten Dotiergebieten oberhalb einer Substratoberfläche ausgebildet ist, erhält man eine Bitleitungsstruktur insbesondere zur Realisierung von SNOR-Architekturen mit wesentlich verringertem Flächenbedarf.

Vorzugsweise wird als Substrat ein Siliziumhalbleiterwafer, als Abdeck-Verbindungsschicht Polysilizium und als Anschlussschicht ein Silizid verwendet, wodurch auf besonders einfache Weise und bei minimalen Strukturgrößen die vergrabene Bitleitung mit den zugehörigen Dotiergebieten verbunden werden kann.

Insbesondere bei einer unmittelbaren Berührung der Vielzahl von Verbindungsschichten mit dem Substrat erhält man eine verbesserte Substratkontaktierung bzw. Wannenkontaktierung, sofern darin Wannen ausgebildet sind, wodurch sich beispielsweise ein homogeneres Tunneln, eine verbesserte Endurance hinsichtlich der Anzahl von Schreib-/Lösch-Zyklen und eine Verringerung von parasitären Dioden realisieren lässt. Ferner können dadurch insbesondere bei einem Mehrfach-Wannenaufbau im Substrat flächenaufwändige Wannenkontakte eliminiert werden, wodurch sich ein Flächenbedarf weiter verringert.

Hinsichtlich des Verfahrens zur Herstellung einer Bitleitungsstruktur werden insbesondere in einem Graben mit einer Grabenisolationsschicht eine vergrabene Bitleitung mit einer darüber liegenden Abdeck-Isolationsschicht ausgebildet, wobei nach dem Ausbilden der Dotiergebiete unter Verwendung von lediglich einer Maske sowohl Teilbereiche der Abdeck-Isolationsschicht entfernt und darin eine Vielzahl von Abdeck-Verbindungsschichten ausgebildet werden, die anschließend über eine Vielzahl von Abschlussschichten die vergrabene Bitleitung mit den zweiten Dotiergebieten elektrisch verbinden. Auf diese Weise kann die flächenoptimierte Bitleitungsstruktur sehr einfach und im Wesentlichen selbstjustierend ausgebildet werden.

Vorzugsweise besteht die Abdeck-Isolationsschicht aus einer mittels eines TEOS-Abscheideverfahrens ausgebildeten zweiten Abdeck-Teilschicht, die teilweise bzw. halbseitig entfernt wird und mit der Abdeck-Verbindungsschicht in unmittelbarer Verbindung zum Substrat ausgebildet wird. Unter Verwendung von entsprechend dotierten Halbleitermaterialien kann auf diese Weise sowohl eine Isolierung als auch eine Kontaktierung des Substrats von der vergrabenen Bitleitung realisiert werden.

Alternativ kann die Abdeck-Isolationsschicht auch eine mittels eines Spacerverfahrens ausgebildete Abdeck-Opferschicht aufweisen, die mittels eines selektiven Ätzverfahrens teilweise bzw. halbseitig entfernt wird, wodurch man bei weiterhin verringertem Flächenbedarf weit verbesserte Abschirmeigenschaften in Form einer aktiven Abschirmung durch die vergrabene Bitleitung im Graben erhält.

In den weiteren Unteransprüchen sind weitere vorteilhafte Ausgestaltungen der Erfindung gekennzeichnet.

Die Erfindung wird nachstehend an Hand von Ausführungsbeispielen unter Bezugnahme auf die Zeichnung näher beschrieben.

Es zeigen:
- Figur 1: ein vereinfachtes Ersatzschaltbild einer SNOR- Architektur;
- Figur 2: eine vereinfachte Draufsicht eines Layouts gemäß Figur 1 mit einer herkömmlichen Bitleitungsstruk- tur;
- Figur 3: eine vereinfachte Draufsicht eines Layouts einer Halbleiterschaltung mit einer erfindungsgemäßen Bitleitungsstruktur;
- Figur 4: eine vereinfachte Schnittansicht der Halbleiter- schaltungsanordnung gemäß Figur 3 zur Veranschauli- chung einer Bitleitungsstruktur gemäß einem ersten Ausführungsbeispiel;
- Figuren 5A bis 5I: vereinfachte Schnittansichten zur Veranschaulichung wesentlicher Verfahrensschritte bei der Herstellung einer Bitleitungsstruktur gemäß dem ersten Ausfüh- rungsbeispiel;
- Figuren 6A bis 6F2: vereinfachte Schnittansichten zur Veranschaulichung wesentlicher Verfahrensschritte bei der Herstellung einer Bitleitungsstruktur gemäß einem zweiten oder dritten Ausführungsbeispiel; und
- Figur 7: eine vereinfachte Schnittansicht zur Veranschauli- chung einer Bitleitungsstruktur gemäß einem vierten Ausführungsbeispiel.

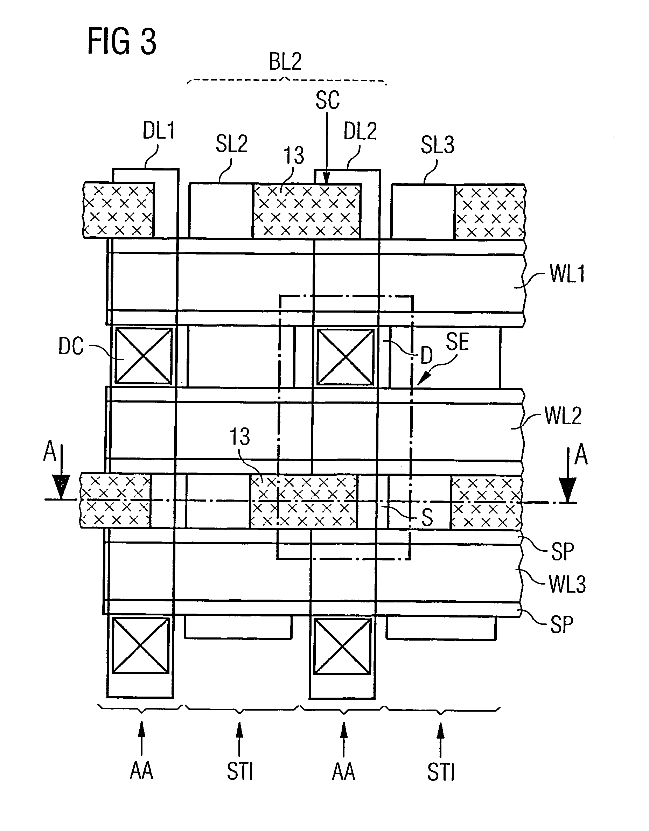

Figur 3 zeigt eine vereinfachte Draufsicht zur Veranschaulichung einer erfindungsgemäßen Bitleitungsstruktur wie sie beispielsweise in einer SNOR-Halbleiterspeicherschaltung eingesetzt werden kann. Gleiche Bezugszeichen bezeichnen hierbei gleiche oder entsprechende Elemente bzw. Schichten wie in den Figuren 1 und 2.

Gemäß Figur 3 wird in einem Substrat, welches beispielsweise ein Halbleitersubstrat und vorzugsweise Silizium aufweist, mittels einer Vielzahl von streifenförmigen Grabenisolationen STI eine Vielzahl von streifenförmigen aktiven Gebieten AA spaltenförmig im Substrat ausgebildet. Wie beim Stand der Technik gemäß Figur 2 sind Wortleitungsstapel WLx mit x = 1 bis n senkrecht zu diesen streifenförmigen aktiven Gebieten AA an der Oberfläche des Substrats zeilenförmig ausgebildet, wobei sie zur Realisierung von beispielsweise nichtflüchtigen Speicherelementen eine erste Isolierschicht, wie z.B. eine Gateoxidschicht oder Tunnelschicht, eine ladungsspeichernde Schicht, wie z.B. ein Floating Gate, eine zweite Isolierschicht, wie z.B. ein Zwischendielektrikum, und eine Steuerschicht als eigentliche ansteuernde Wortleitung aufweisen. An den Seitenwänden der Wortleitungsstapel WLx sind zu Isolationszwecken Seitenwandisolierschichten bzw. Spacer SP ausgebildet. An jedem Kreuzungspunkt bzw. Überlappungspunkt zwischen den aktiven Gebieten AA und den Wortleitungsstapeln WLx wird demzufolge ein Schaltelement bzw. ein nichtflüchtiges Speicherelement SE ausgebildet, welches zur Realisierung einer Feldeffekttransistorstruktur Draingebiete D und Sourcegebiete S als erste und zweite Dotiergebiete an den Seiten der Wortleitungsstapel aufweisen.

Zur Realisierung der erfindungsgemäßen flächenoptimierten Halbleiterschaltung wird jedoch nunmehr die Bitleitungsstruktur bestehend aus einem Sourceleitungs- und Drainleitungspaar SLx und DLx mit x = 1 bis m nicht ausschließlich an der Oberfläche des Substrats, sondern zum Einen als vergrabene Bitleitung SLx in der Grabenisolierung STI innerhalb des Substrats und zum Anderen als Oberflächenbitleitung DLx an bzw. oberhalb der Substratoberfläche ausgebildet. Genauer gesagt ist die vergrabene Bitleitung SLx in den tieferen Schichten der Grabenisolierung STI eingebettet und wird über lokal ausgebildete selbstjustierende Anschlussschichten 13 an die zu kontaktierenden Sourcegebiete S angeschlossen. Andererseits wird die beispielsweise in einer ersten Metallisierungsebene ausgebildete Oberflächenbitleitung DLx über Kontakte DC mit zugehörigen Draingebieten D der Schaltelemente SE verbunden. Auf diese Weise erhält man eine hinsichtlich des Flächenbedarfs optimierte Bitleitungsstruktur, bei der insbesondere die Pitchdimensionen (Strukturbreite + Strukturabstand) wesentlich verringert werden können.

Gemäß Figur 3 ist die Oberflächenbitleitung DLx streifenförmig oberhalb der aktiven Gebiete AA ausgebildet. Aufgrund dieses geradlinigen Streifendesigns können diese relativ einfach lithografisch definiert werden. Dies wird insbesondere in der Zukunft bedeutend werden. Sie kann in gleicher Weise jedoch auch eine andere Form aufweisen.

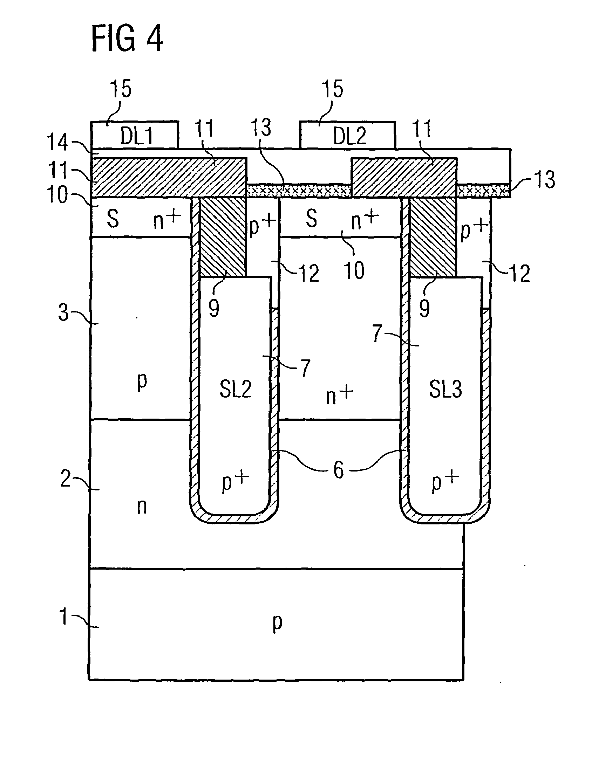

Figur 4 zeigt eine vereinfachte Schnittansicht entlang eines Schnitts A-A gemäß Figur 3, wobei gleiche Bezugszeichen wiederum gleiche Elemente bzw. Schichten bezeichnen und auf eine wiederholte Beschreibung nachfolgend verzichtet wird.

Gemäß Figur 4 weist ein Halbleitersubstrat einen Mehrschichtaufbau bzw. einen Mehrfach-Wannenaufbau auf, wobei in einem eigentlichen Halbleitersubstrat 1 bzw. einer tiefen p-Wanne 1 eine erste beispielsweise p-Wanne 3 und eine zweite beispielsweise n-Wanne 2 ausgebildet sind. Ein derartiger Mehrfach-Wannenaufbau ist insbesondere hinsichtlich seiner Abschirmwirkung und seiner Isolationseigenschaften vorteilhaft, da auch in tiefen Regionen des Substrats ausreichende Isolierschichten beispielsweise mittels Raumladungszonen ausgebildet werden können und darüber hinaus komplexe Strukturen realisierbar sind.

Im Halbleitersubstrat bzw. in den zugehörigen Schichten oder Wannen 1, 2 und 3 sind nunmehr tiefe Gräben ausgebildet, die an ihren Grabenwänden eine Grabenisolationsschicht 6 aufweisen. In einem unteren Bereich der Gräben mit ihrer Grabenisolationsschicht 6 ist nunmehr die eigentlich vergrabene Bitleitung SLx mittels einer elektrisch leitenden Füllschicht 7 ausgebildet, wobei in einem oberen Teilbereich des Grabens bzw. an einer Halbseite eine Abdeck-Isolationsschicht mit vorzugsweise einer zweiten Abdeck-Teilschicht 9 ausgebildet ist, die vorzugsweise mittels eines STI-Verfahrens (Shallow Trench Isolation) ausgebildet wird. Auf diese Weise erhält man gemäß Figur 4 zur linken Halbseite hervorragende Isolationseigenschaften insbesondere in einem oberen Bereich des Grabens.

Im weiteren oberen Teilbereich des Grabens bzw. an der rechten Halbseite ist die Isolationsschicht 9 sowie die Grabenisolationsschicht 6 bei zugehörigen zweiten Dotiergebieten 10 bzw. Sourcegebieten S vollständig entfernt und dafür eine Vielzahl von Anschlussverbindungsschichten 12, welche wiederum elektrisch leitend sind und die vergrabene Bitleitung bzw. Füllschicht 7 kontaktieren, ausgebildet. Die zweiten Dotiergebiete 10 sind an der Substratoberfläche zwischen den Isolationsgraben ausgebildet und grenzen vorzugsweise unmittelbar an die Gräben an. Zum Anschließen dieser zweiten Dotiergebiete 10 an die vergrabene Bitleitung SLx sind nunmehr im Bereich der Substratoberfläche und gemäß Figur 4 unmittelbar an der Oberflache des Substrats selbstjustierende Anschlussschichten 13 zwischen einer Maskenschicht 11 ausgebildet. Diese selbstjustierenden Anschlussschichten 13 bestehen im Falle von Silizium-Halbleitermaterial aus Siliziden bzw. Saliziden (self aligned silicides).

Zur Isolierung des Substrats, der zweiten Dotiergebiete 10 bzw. der Anschlussschichten 13 von den darüber liegenden Schichten ist ferner eine Zwischenisolierschicht 14 ausgebildet, an deren Oberfläche schließlich die strukturierten Oberflächenbitleitungen DLx in Form von strukturierten elektrisch leitenden Schichten 15 streifenförmig ausgebildet sind.

Auf diese Weise erhält man erstmalig auch für SNOR-Architekturen eine flächenoptimierte Bitleitungsstruktur, welche insbesondere geringe Anforderungen hinsichtlich des Pitchs (Strukturbreite + Strukturabstand) in Metallisierungsebenen aufweist.

Gemäß Figur 4 wird als vergrabene Bitleitung bzw. elektrische Füllschicht 7 und als Abdeck-Verbindungsschicht 12 ein Halbleitermaterial (z.B. Si) vom zum zweiten Dotiergebiet 10 entgegengesetzten Leitungstyp p⁺ verwendet. Genauer gesagt wird für die Füllschicht 7 und die Abdeck-Verbindungsschicht 12 beispielsweise ein p⁺-dotiertes Halbleitermaterial verwendet, während das Sourcegebiet S n⁺-dotiert ist und sich in der p-dotierten Wanne 3 befindet. Bei einer derartigen Konstellation, bei der insbesondere die Vielzahl von Verbindungsschichten 12 aufgrund der fehlenden Grabenisolationsschicht 6 im oberen Teilbereich des Grabens unmittelbar das Substrat bzw. die p-Wanne 3 berühren, kann mittels der vergrabenen Bitleitung nicht nur das Sourcegebiet S kontaktiert werden, sondern darüber hinaus auch die p-Wanne 3, wodurch sich insbesondere bei nichtflüchtigen Speicherelementen, wie z.B. Flash-EPROM-Elementen, ein homogeneres Tunnelverhalten und eine erhöhte Anzahl von Schreib-/Lösch-Zyklen (endurance) realisieren lässt. Ferner können parasitäre Dioden oder Leckströme dadurch wesentlich verringert werden. Ein weiterer Vorteil einer derartigen unmittelbaren Kontaktierung des Substrats bzw. einer Wanne des Substrats über die Verbindungsschicht 12 ist die Einsparung von Oberflächenkontakten, die üblicherweise notwendig wären, um ein gleichmäßiges Potential in einer derartigen Wanne zu realisieren. Auf diese Weise kann demzufolge eine Anforderung an das Layout wesentlich entspannt werden.

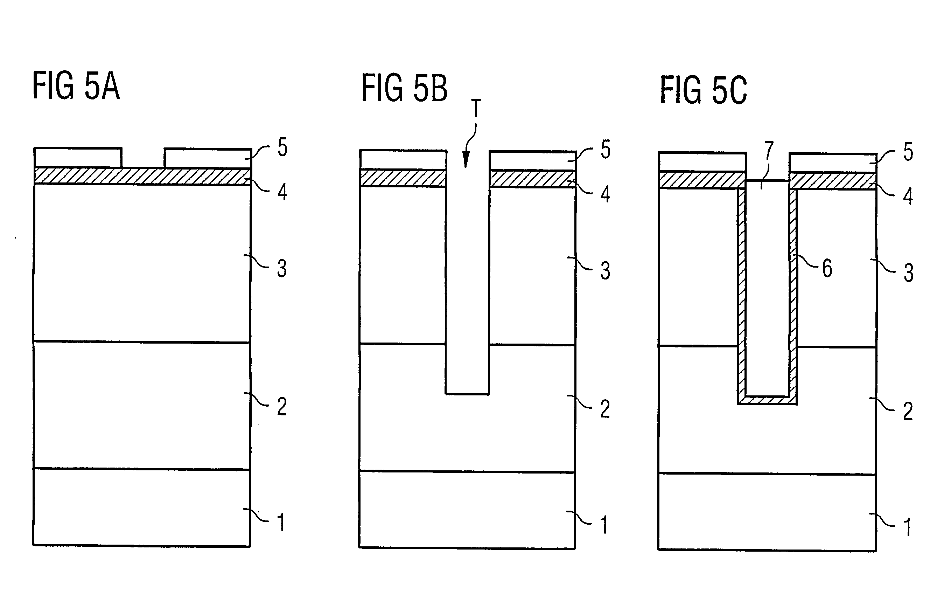

Figuren 5A bis 5I zeigen vereinfachte Schnittansichten zur Veranschaulichung wesentlicher Verfahrensschritte bei der Herstellung einer Bitleitungsstruktur gemäß Figur 4, wobei gleiche Bezugszeichen wiederum gleiche oder entsprechende Elemente bzw. Schichten bezeichnen und auf eine wiederholte Beschreibung nachfolgend verzichtet wird.

Gemäß Figur 5A werden demzufolge in einem Substrat eine Vielzahl von Wannen beispielsweise mittels Ionenimplantation ausgebildet, wobei beispielsweise eine tiefe p-Wanne 1, eine flache erste Wanne 3 und eine zweite n-Wanne 2 ausgebildet wird. Selbstverständlich kann die tiefe Wanne 1 auch bereits das eigentliche Substrat darstellen oder eine noch größere Anzahl von Wannen im Substrat ausgebildet sein. Anschließend wird an der Oberfläche des Halbleitermaterials eine erste Hilfs-Isolationsschicht 4 beispielsweise durch Abscheiden oder Aufwachsen einer Oxidschicht ausgebildet. Anschließend erfolgt das Ausbilden und Strukturieren einer Hartmaskenschicht 5, wobei vorzugsweise Siliziumnitrid an der Oberfläche der ersten Hilfs-Isolationsschicht 4 ausgebildet wird. Die Strukturierung der Hartmaskenschicht 5 erfolgt mit herkömmlichen fotolithografischen Verfahren und dient im Wesentlichen zum Festlegen der auszubildenden Gräben.

Gemäß Figur 5B wird nunmehr mittels der strukturierten Hartmaske 5 ein tiefer Graben T im Substrat ausgebildet, wobei er sich gemäß den beschriebenen Ausführungsbeispielen bis in die zweite Wanne 2 hinein erstreckt. Vorzugsweise wird hierbei ein anisotropes Ätzverfahren, wie z.B. reaktives Ionenätzen (RIE), verwendet. Dieser Ätzschritt wird beispielsweise mit einem Reinigungsschritt abgeschlossen, wobei Polymere bzw. Polymerreste entfernt werden.

Gemäß Figur 5C wird anschließend eine Grabenisolationsschicht 6 ganzflächig an der Grabenoberfläche des Grabens T ausgebildet, wobei vorzugsweise eine thermische Oxidation zum Ausbilden eines sogenannten Liner-Oxids durchgeführt wird. Grundsätzlich können jedoch auch andere Isolierschichten an Stelle des Siliziumdioxids als Grabenisolationsschichten 6 verwendet werden, wobei insbesondere auch isolierende Mehrfachschichten realisiert werden können.

Anschließend wird zur Realisierung der vergrabenen Bitleitung eine elektrisch leitende Füllschicht 7 im Graben T bzw. an der Oberfläche der Grabenisolationsschicht 6 ausgebildet. Vorzugsweise wird hierbei hochdotiertes Polysilizium im Graben abgeschieden, wobei die Dotierung abhängig von der verwendeten ersten Wanne 3 und einer beabsichtigten Kontaktierung gewählt wird. Grundsätzlich können jedoch auch andere elektrisch leitende Schichten, wie beispielsweise Metalle, als vergrabene Bitleitung SLx im Graben ausgebildet werden.

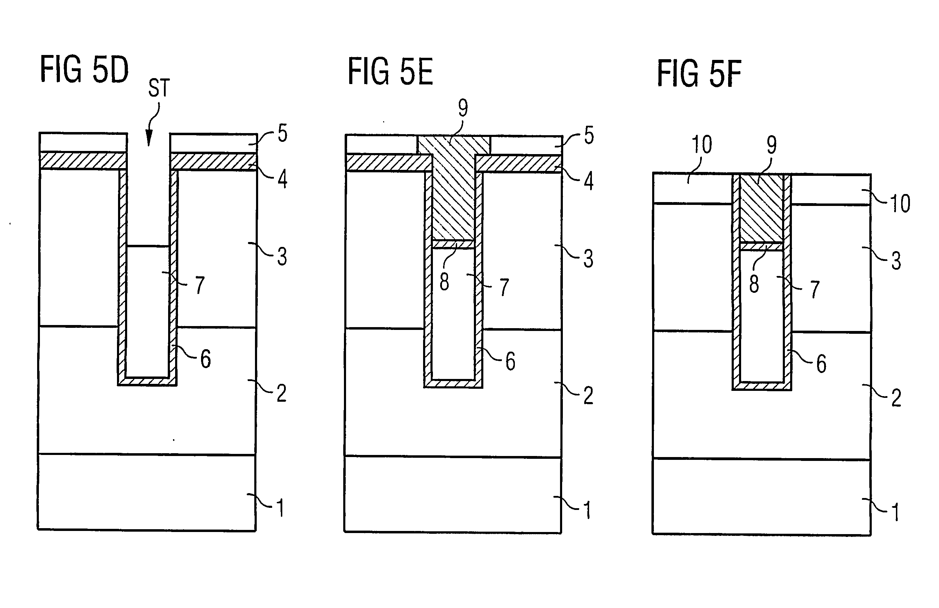

Gemäß Figur 5D erfolgt in einem nachfolgenden Schritt zunächst ein Rückbilden der elektrisch leitenden Füllschicht 7, wobei beispielsweise ein STI-Verfahren zur Realisierung von flachen Grabenisolierungen verwendet werden kann und flache Gräben ST entstehen. Auf die einzelnen Verfahrensschritte eines derartigen herkömmlichen STI-Verfahrens wird nachfolgend nicht eingegangen, da sie dem Fachmann allgemein bekannt sind.

Gemäß Figur 5E können hierbei nach einem vorzugsweise anisotropen Ätzschritt auch die Graben-Kanten der Hartmaskenschicht 5 zurückgeätzt werden, was als sogenanntes "Nitrid-Pullback" bezeichnet wird. Auf diese Weise erhält man eine gewisse Entspannung der Grabenkanten für die weitere Prozessierung und auch verbesserte elektrische Eigenschaften von beispielsweise in der Halbleiterschaltung ebenso vorhandenen CMOS-Transistoren.

Anschließend kann ferner eine erste Abdeck-Teilschicht 8 als Isolationsschicht an der Oberfläche der zurückgeätzten Füllschicht 7 ausgebildet werden, wobei wiederum vorzugsweise eine thermische Oxidation zur Ausbildung eines weiteren Liner-Oxids durchgeführt wird. Abschließend erfolgt eine Ausbildung einer zweiten Abdeck-Teilschicht 9 als weiterer Isolationsschicht, wobei vorzugsweise mittels eines TEOS-Abscheideverfahrens der obere Bereich des Grabens vollständig mit Siliziumdioxid aufgefüllt wird. Nach einem Planarisierschritt, wie beispielsweise einem CMP-Verfahren (Chemical Mechanical Polishing), bei dem die Hartmaskenschicht 5 als Stoppschicht verwendet wird, erhält man die in Figur 5E dargestellte Schnittansicht.

Gemäß Figur 5F wird anschließend die Hartmaskenschicht 5 bzw. das Siliziumnitrid vollständig entfernt und optional ebenfalls die erste Hilfs-Isolationsschicht 4. Zu diesem Zeitpunkt werden beispielsweise an den jeweiligen Bereichen des aktiven Gebietes AA eine (nicht dargestellte) erste Isolierschicht, bzw. Gateoxidschicht oder Tunneloxidschicht, am Halbleitersubstrat ausgebildet. Im Bereich der Schnittdarstellung ist jedoch eine derartige erste Isolierschicht nicht notwendig, weshalb sie entfällt und lediglich die (nicht dargestellten) ersten und (dargestellten) zweiten Dotiergebiete 10 nunmehr als Source- und Draingebiete an der Oberfläche des Halbleitersubstrats ausgebildet werden. Das Ausbilden dieser Dotiergebiete 10 erfolgt beispielsweise mittels herkömmlicher Implantationsverfahren, wobei auch LDD- bzw. Anschlussimplantationen unter Verwendung von jeweiligen Spacern durchgeführt werden können.

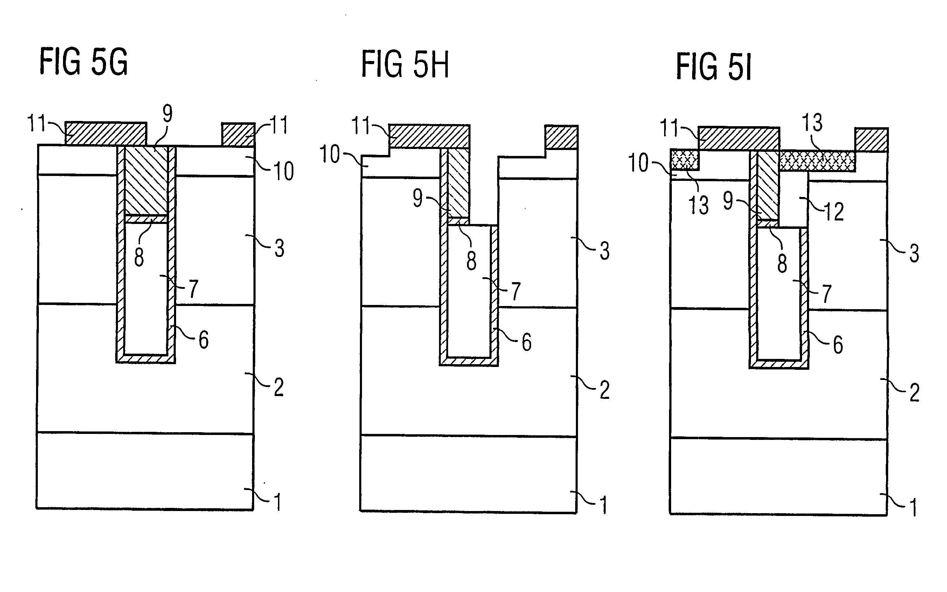

Gemäß Figur 5G wird anschließend eine Maskenschicht 11 bzw. Caplayer 11 ausgebildet und derart strukturiert, dass lediglich jeweils ein Teilbereich z.B. eine Halbseite des Grabens abgedeckt ist. Zur Realisierung dieser Maskenschicht 11 wird beispielsweise Siliziumdioxid oder Siliziumnitrid abgeschieden und strukturiert, wobei auch andere Materialien wie z.B. neuartige Metalloxide (ZrO2,Al2O3,..) verwendet werden können.

Gemäß Figur 5H wird anschließend unter Verwendung der Maskenschicht 11 und Durchführung eines beispielsweise stark selektiven anisotropen Oxid-Ätzverfahrens der freiliegende Teilbereich der Abdeck-Isolationsschicht, bestehend aus der Grabenisolationsschicht 6 und der ersten zweiten Abdeck-Teilschicht 8 und 9, vollständig entfernt, bis die Füllschicht 7 freigelegt ist. Hierbei kann es auch zu einem nicht dargestellten Überätzen bzw. einem weiteren Entfernen der Grabenisolationsschicht 6 kommen (siehe Figur 4).

Gemäß Figur 5I wird anschließend die Abdeck-Verbindungsschicht 12 bzw. auf den ganzen Graben gesehen eine Vielzahl von Abdeck-Verbindungsschichten an den jeweiligen Stellen in den zurückgeätzten Teilbereichen des Grabens ausgebildet, wobei vorzugsweise eine Abscheidung von insitu-dotiertem Polysilizium durchgeführt wird.

Nach diesem Ausbilden der Abdeck-Verbindungsschicht 12, die elektrisch leitend mit der Füllschicht 7 in Verbindung steht, erfolgt eine zusätzliche Rückätzung der ersten und zweiten Dotiergebiete 10 im Substrat, wodurch sichergestellt wird, dass keine parasitären Kurzschlüsse zwischen benachbarten Source-Gebieten aufgrund von Resten der Abdeck-Verbindungsschicht 12 existieren. Anschließend wird an der Oberfläche der Abdeck-Verbindungsschicht 12 und der Dotiergebiete 10 eine Vielzahl von selbstjustierenden Anschlussschichten 13 ausgebildet, wodurch man eine elektrische Verbindung zwischen den Dotiergebieten 10 und der Abdeck-Verbindungsschicht 12 bzw. den vergrabenen Bitleitungen erhält. Zur Realisierung derartiger hochleitfähiger Anschlussbereiche 13 wird beispielsweise zunächst silizierfähiges Material bzw. eine silizierfähige Metallschicht, wie z.B. Kobalt, Nickel oder Platin, ganzflächig abgeschieden. Anschließend wird eine Umwandlung der Oberflächenschicht des Halbleitermaterials, der Abdeck-Verbindungsschicht 12 und der Dotiergebiete 10 unter Verwendung des silizierfähigen Materials zum Ausbilden der hochleitfähigen Anschlussbereiche 13 durchgeführt, wobei an den nicht mit Halbleitermaterial (Silizium) in Berührung stehenden Oberflächen, d.h. an der Maskenschicht 11, kein Silizid ausgebildet wird, sondern das abgeschiedene Material (Metall) bestehen bleibt, weshalb wiederum mittels eines vorzugsweise nass-chemischen Ätzverfahrens eine selektive Rückätzung der abgeschiedenen - aber nicht silizidierten - Metallschicht erfolgen kann. Auf diese Weise kann mittels einer einzigen Maske bzw. Maskenschicht 11 sowohl das selbstjustierende Ausbilden der Abdeck-Verbindungsschicht 12 und der Anschlussschichten 13 durchgeführt werden, wobei bei geeigneter Auswahl von Dotiermaterialien darüber hinaus eine unmittelbare Wannenkontaktierung der ersten Wanne 3 ermöglicht ist.

In den weiteren (nicht dargestellten) Schritten kann beispielsweise die Maskenschicht 11 wieder entfernt werden und die in Figur 4 dargestellte Zwischenisolierschicht 14 sowie die Metallisierungsschicht 15 zur Realisierung der Oberflächenbitleitungen DLx ausgebildet und strukturiert werden. Abschließend erfolgt ein Ausbilden einer Vielzahl von Kontakten (DC) zum elektrischen Verbinden der Oberflächenbitleitung (DLx) mit den ersten Dotiergebieten (D).

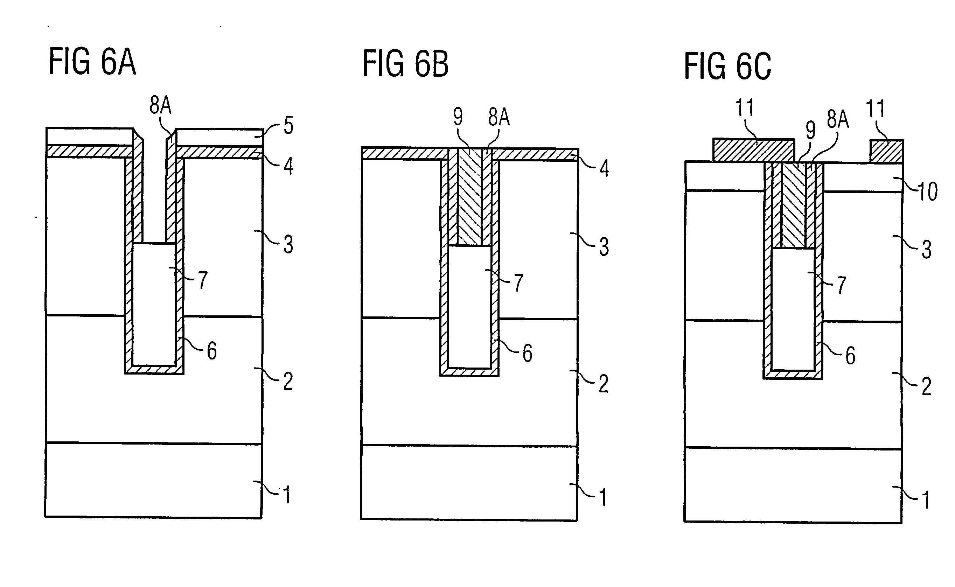

Figuren 6A bis 6F2 zeigen vereinfachte Schnittansichten zur Veranschaulichung wesentlicher Verfahrensschritte bei der Herstellung einer Bitleitungsstruktur gemäß einem zweiten oder dritten Ausführungsbeispiel, wobei gleiche Bezugszeichen gleiche oder entsprechende Schichten wie in den Figuren 1 bis 5 bezeichnen und auf eine wiederholte Beschreibung nachfolgend verzichtet wird.

Zunächst werden wiederum vorbereitende Schritte zum Ausbilden insbesondere des Grabens T, der Grabenisolationsschicht 6 und der rückgeätzten Füllschicht 7 gemäß Figuren 5A bis 5D durchgeführt, weshalb an dieser Stelle explizit auf die entsprechende Beschreibung verwiesen wird.

Gemäß Figur 6A wird nach einem Verfahrensschritt, wie er beispielsweise in Figur 5D dargestellt ist, nunmehr nicht eine vollständige Auffüllung des oberen Grabenbereiches mit der ersten und zweiten Abdeck-Teilschicht 8 und 9, sondern zunächst eine Abdeck-Opferschicht 8A an der Oberfläche der Grabenisolationsschicht 6 im oberen Grabenbereich beispielsweise mittels eines Spacerverfahrens ausgebildet. Die Abdeck-Opferschicht 8A sollte hierbei eine von der Grabenisolationsschicht 6 und einer nachfolgend auszubildenden Isolations-Füllschicht 9 unterschiedliche Ätzselektivität aufweisen. Auf die Beschreibung eines derartigen Spacerverfahrens (Ausbilden einer konformen Schicht + anisotropes Rückätzen) wird nachfolgend verzichtet, da es dem Fachmann allgemein bekannt ist.

Gemäß Figur 6B wird anschließend vergleichbar zum Verfahrensshritt gemäß Figur 5E eine zweite Abdeck-Teilschicht 9 zum vollständigen Auffüllen des Grabens mittels beispielsweise eines TEOS-Abscheideverfahrens ausgebildet, wobei anschließend ein Planarisierverfahren (CMP) durchgeführt und die Hartmaskenschicht 5 entfernt wird.

Gemäß Figur 6C erfolgt wiederum das Ausbilden und Strukturieren einer Maskenschicht 11 derart an der Oberfläche des Substrats, dass zumindest ein Teilbereich des Grabens von der Maskenschicht 11 bedeckt ist, wobei vorzugsweise eine Hälfte des Grabens bzw. der im oberen Graben befindlichen Grabenisolation bedeckt wird.

Gemäß Figur GD kann nunmehr gemäß einem zweiten Ausführungsbeispiel ein hochselektives isotropes Ätzverfahren zum Entfernen der Abdeck-Opferschicht 8A durchgeführt werden, wobei beispielsweise bei Verwendung einer Siliziumnitridschicht als Abdeck-Opferschicht 8A Phosphorsäure als Ätzmittel verwendet werden kann. Nachteilig ist hierbei jedoch, dass für die Maskenschicht 11 beispielsweise keine Siliziumschichten verwendet werden können, wobei jedoch Isolationsschichten, wie beispielsweise Al₂O₃, ZrO₂, HfO₂ u.s.w. (Metalloxide), als Maskenschicht 11 geeignet sind.

Auf diese Weise erhält man ein Kontaktloch zur Füllschicht 7, die zum Substrat bzw. zur ersten Wanne 3 vollständig durch die Grabenisolationsschicht 6 isoliert ist, wodurch man für bestimmte Anwendungsfälle verbesserte Isolationseigenschaften erhält und eine Verkleinerung der Zellfläche erreicht, da man in diesem Fall aufgrund der Selbstjustierung keinen Fototechnischen Vorhalt wegen typischer Verjustierungen einplanen muss.

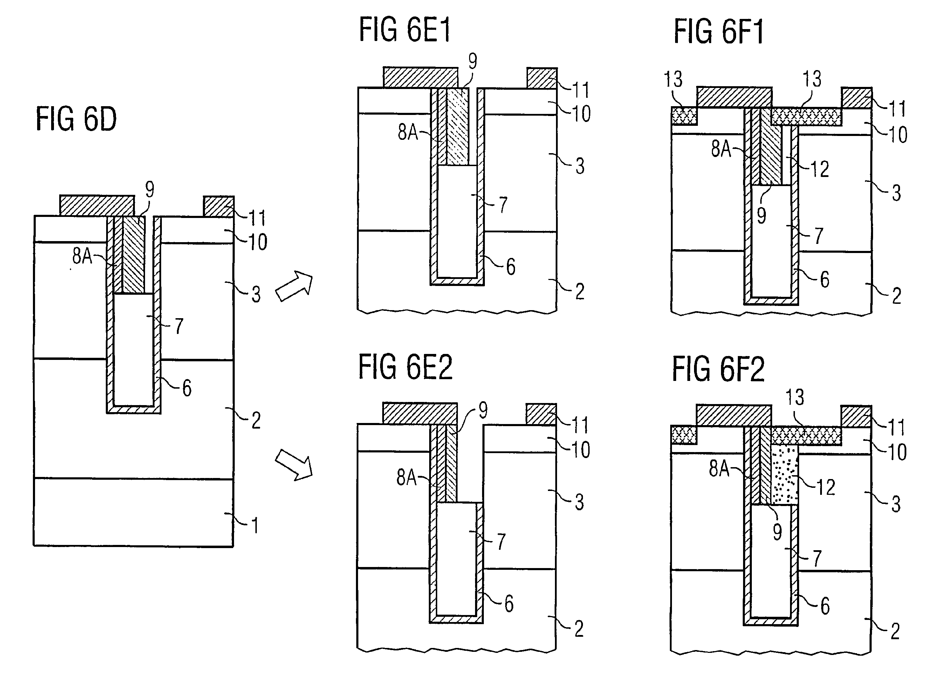

Gemäß Figur 6E1 wird bei diesem zweiten Ausführungsbeispiel demzufolge die Grabenisolationsschicht 6 auch im oberen freigelegten bzw. nicht maskierten Bereich beibehalten, wodurch sich ferner bei einem nachfolgend durchgeführten Dünnen bzw. Rückbilden der Dotiergebiete 10 eine geringeres Risiko für ein Überätzen einstellt.

Gemäß Figur 6F1 wird anschließend wiederum die Abdeck-Verbindungsschicht 12 wie in Figur 5I ausgebildet, (optional) das Dotiergebiet 10 zurückgebildet und die hochleitfähige Anschlussschicht 13 selbstjustierend ausgebildet. Auf diese Weise erhält man eine vergrabene Bitleitungsstruktur, wobei die vergrabene Bitleitung nicht mit dem Substrat oder der ersten Wanne 3 in Berührung steht und folglich eine höhere Flexibilität hinsichtlich der Anschlusspotentiale besteht.

Gemäß Figur 6E2 bzw. einem dritten Ausführungsbeispiel kann jedoch in einem weiteren vorzugsweise nass-chemischen Ätzverfahren unter Verwendung der Maskenschicht 11 wiederum auch die Grabenisolationsschicht 6 im freigelegten oberen Bereich des Grabens vollständig entfernt werden, wodurch man wiederum eine unmittelbare Kontaktierung des Substrats bzw. der ersten Wanne 3 bei entsprechender Dotierung der verwendeten Halbleitermaterialien erhält.

Figur 6F2 zeigt die abschließenden Schritte zur Realisierung der Abdeck-Verbindungsschicht 12 und der hochleitfähigen Anschlussschicht 13, wobei wiederum auf die Beschreibung gemäß Figur 5I verwiesen wird.

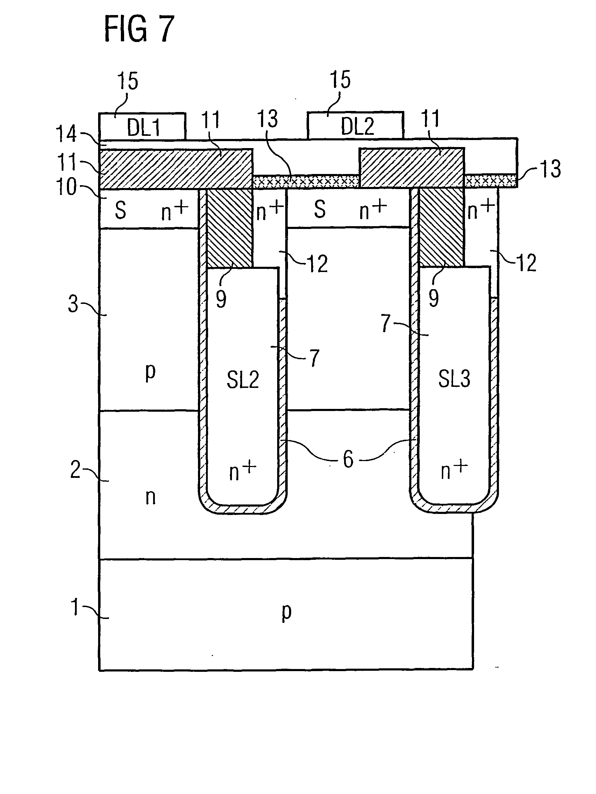

Figur 7 zeigt eine vereinfachte Schnittansicht einer Bitleitungsstruktur gemäß einem vierten Ausführungsbeispiel, wobei gleiche Bezugszeichen wiederum gleiche oder entsprechende Schichten insbesondere wie in Figur 4 bezeichnen und auf eine wiederholte Beschreibung nachfolgend verzichtet wird.

Die Figur 7 entspricht im Wesentlichen dem Aufbau gemäß Figur 4, wobei jedoch zur Realisierung der Füllschicht 7 und der Abdeck-Verbindungsschicht 12 nunmehr ein Halbleitermaterial verwendet wird, welches den gleichen Leitungstyp aufweist, wie das Dotiergebiet 10. Genauer gesagt wird beispielsweise als Füllschicht 7 und Abdeck-Verbindungsschicht 12 insitu-dotiertes n⁺-Polysilizium verwendet, welches mit dem n⁺-dotierten Sourcegebiet S bereits einen elektrisch leitenden Kontakt eingehen kann. Da jedoch nunmehr die Abdeck-Verbindungsschicht 12 und das Substrat bzw. die erste Wanne 3 eine Dotierung vom entgegengesetzten Leitungstyp aufweisen, entstehen an deren Berührungsflächen sogenannte Verarmungs- bzw. Raumladungszonen, die eine isolierende Wirkung in ähnlicher Weise wie die Grabenisolationsschicht 6 beim zweiten Ausführungsbeispiel gemäß Figur 6F1 bewirken. Auf diese Weise erhält man auch unter Verwendung der Verfahrensschritte gemäß Figuren 5 und der zweiten Alternative in Figur 6 eine Wannenisolierung zwischen der vergrabenen Bitleitung und dem Substrat bzw. einer zugehörigen Wanne.

Ferner sei in diesem Zusammenhang darauf hingewiesen, dass die hochleitfähigen Verbindungsschichten 13 nicht innerhalb des Substrats, d.h. in die Dotiergebiete 10 eingesenkt ausgebildet werden müssen, sondern in gleicher Weise teilweise oder ganz an der Oberfläche des Substrats ausgebildet werden können.

Die Erfindung wurde vorstehend an Hand einer nichtflüchtigen SNOR-Halbleiterspeicherschaltung beschrieben. Sie ist jedoch nicht darauf beschränkt und umfasst in gleicher Weise weitere Halbleiterspeicherschaltungen, die eine entsprechende Bitleitungsstruktur aufweisen. Ferner ist die Erfindung nicht auf die beschriebenen Silizium-Halbleitersubstrate und Materialien beschränkt, sondern umfasst in gleicher Weise alternative Halbleitermaterialien mit entsprechenden Dotierungen oder Isoliermöglichkeiten.

## Patentansprüche

1. Bitleitungsstruktur mit
einer vergrabenen Bitleitung (SLx), die zum Anschließen einer Vielzahl von zweiten Dotiergebieten (S; 10) innerhalb eines Substrats (1, 2, 3) derart ausgebildet ist, dass
ein Graben (T) im Substrat (1, 2, 3);
eine Grabenisolationsschicht (6) an einer Grabenoberfläche des Grabens (T);
die vergrabene Bitleitung (SLx, 7) in einem unteren Bereich des Grabens (T) auf der Grabenisolationsschicht (6);
eine Abdeckisolationsschicht (8, 8A, 9) auf der vergrabenen Bitleitung (SLx) in einem ersten oberen Teilbereich des Grabens (T);
eine Vielzahl von Abdeck-Verbindungsschichten (12) auf der vergrabenen Bitleitung (SLx) in einem zweiten oberen Teilbereich des Grabens (T); und
eine Vielzahl von Anschlussschichten (13) im Bereich der Substratoberfläche ausgebildet sind, wobei die Vielzahl von Abdeck-Verbindungsschichten (12) über die Anschlussschichten (13) mit der Vielzahl von zweiten Dotiergebieten (S, 10) elektrisch verbunden sind,
**dadurch gekennzeichnet, dass**
eine Oberflächenbitleitung (DLx) zum Anschließen einer Vielzahl von ersten Dotiergebieten (D) oberhalb einer Substratoberfläche ausgebildet ist.

2. Bitleitungsstruktur nach Patentanspruch 1, **dadurch gekennzeichnet, dass** die Abdeckisolationsschicht (8, 9) eine flache Grabenisolation darstellt.

3. Bitleitungsstruktur nach Patentanspruch 1 oder 2, **dadurch gekennzeichnet, dass** das Substrat (1, 2, 3) kristallines Silizium, die Vielzahl von Abdeck-Verbindungsschichten (12) hochdotiertes Polysilizium und die Vielzahl von Anschlussschichten (13) ein Silizid aufweisen.

4. Bitleitungsstruktur nach einem der Patentansprüche 1 bis 3, **dadurch gekennzeichnet, dass** die Vielzahl von Abdeck-Verbindungsschichten (12) ferner das Substrat (3) unmittelbar berühren.

5. Bitleitungsstruktur nach einem der Patentansprüche 1 bis 4, **dadurch gekennzeichnet, dass** die Vielzahl von Abdeck-Verbindungsschichten (12) einen zum Leitungstyp (n) der zweiten Dotiergebiete (S) gleichen Leitungstyp (n) aufweisen.

6. Bitleitungsstruktur nach einem der Patentansprüche 1 bis 4, **dadurch gekennzeichnet, dass** die Vielzahl von Abdeck-Verbindungsschichten (12) einen zum Leitungstyp (n) der zweiten Dotiergebiete (S) entgegengesetzten Leitungstyp (p) aufweisen.

7. Bitleitungsstruktur nach einem der Patentansprüche 1 bis 6, **dadurch gekennzeichnet, dass** das Substrat (1, 2, 3) einen Mehrfach-Wannenaufbau aufweist.

8. Verfahren zur Herstellung einer Bitleitungsstruktur mit den Schritten:
a) Ausbilden eines Grabens (T) in einem Substrat (1, 2, 3);
b) Ausbilden einer Grabenisolationsschicht (6) an einer Grabenoberfläche des Grabens (T);
c) Ausbilden einer elektrisch leitenden Füllschicht (7) auf der Grabenisolationsschicht (6) des Grabens (T) zur Realisierung einer vergrabenen Bitleitung (SLx);
d) Ausbilden einer Abdeckisolationsschicht (8, 9, 8A) in einem ersten oberen Teilbereich des Grabens (T);
e) Ausbilden von ersten und zweiten Dotiergebieten (10) an der Oberfläche des Substrats (3);
f) Ausbilden einer Vielzahl von Abdeck-Verbindungsschichten (12) auf der Füllschicht (7) in einem zweiten oberen Teilbereich des Grabens (T) in Teilbereichen der Abdeckisolationsschicht; und
g) Ausbilden einer Vielzahl von selbstjustierenden Anschlussschichten (13) zum elektrischen Verbinden der Vielzahl von Abdeck-Verbindungsschichten (12) mit den zweiten Dotiergebieten (10, S), **gekennzeichnet durch** die weiteren Schritte:
h) Ausbilden einer Zwischenisolierschicht (14) an der Oberfläche des Substrats;
i) Ausbilden einer elektrisch leitenden Schicht (15) als Oberflächenbitleitung (DLx); und
j) Ausbilden einer Vielzahl von Kontakten (DC) zum elektrischen Verbinden der Oberflächenbitleitung (DLx) mit den ersten Dotiergebieten (D).

9. Verfahren nach Patentanspruch 8, **dadurch gekennzeichnet, dass** in Schritt a) ein Substrat mit einem Mehrfach-Wannenaufbau und der Graben (T) bis in eine zweite Wanne (2) ausgebildet wird.

10. Verfahren nach Patentanspruch 8 oder 9, **dadurch gekennzeichnet, dass** in Schritt b) eine thermische Oxidation zum Ausbilden eines Liner-Oxids als Grabenisolationsschicht (6) ausgebildet wird.

11. Verfahren nach einem der Patentansprüche 8 bis 10, **dadurch gekennzeichnet, dass** in Schritt c) ein hochdotiertes polykristallines Halbleitermaterial als Füllschicht (7) abgeschieden wird.

12. Verfahren nach einem der Patentansprüche 8 bis 11, **dadurch gekennzeichnet, dass** in Schritt d) die Füllschicht (7) in einem oberen Bereich des Grabens (T) zurückgeätzt wird.

13. Verfahren nach Patentanspruch 12, d a **durch gekennzeichnet, dass** in Schritt d) eine erste Abdeck-Teilschicht (8) an der Oberfläche der zurückgeätzten Füllschicht (7) mittels thermischer Oxidation und eine zweite Abdeck-Teilschicht (9) zum Auffüllen des Grabens (T) mittels eines TEOS-Abscheideverfahrens ausgebildet wird.

14. Verfahren nach einem der Patentansprüche 8 bis 13, **dadurch gekennzeichnet, dass** in Schritt f) eine Vielzahl von Teilbereichen der Abdeckisolationsschicht (8, 9) und der Grabenisolationsschicht (6) im oberen Bereich des Grabens entfernt und insitu-dotiertes Halbleitermaterial zum Ausbilden der Abdeck-Verbindungsschichten (12) abgeschieden und zurückgeätzt wird.

15. Verfahren nach Patentanspruch 12, **dadurch gekennzeichnet, dass** in Schritt d) eine Abdeck-Opferschicht (8A) an der Oberfläche der Grabenisolationsschicht (6) mittels eines Spacerverfahrens und eine zweite Abdeck-Teilschicht (9) zum Auffüllen des Grabens mittels eines TEOS-Abscheideverfahrens ausgebildet wird.

16. Verfahren nach Patentanspruch 15, d a **durch gekennzeichnet, dass** in Schritt f) eine Vielzahl von Teilbereichen der Abdeck-Opferschicht (8A) im zweiten oberen Teilbereich des Grabens (T) entfernt wird und insitu-dotiertes Halbleitermaterial zum Ausbilden der Abdeck-Verbindungsschicht (12) abgeschieden und zurückgeätzt wird.

17. Verfahren nach Patentanspruch 15, d a **durch gekennzeichnet, dass** in Schritt f) eine Vielzahl von Teilbereichen der Abdeck-Opferschicht (8A) der Grabenisolationsschicht (6) und der zweiten Abdeck-Teilschicht (9) im zweiten oberen Teilbereich des Grabens (T) entfernt wird; und insitu-dotiertes Halbleitermaterial zum Ausbilden der Abdeck-Verbindungsschicht (12) abgeschieden und zurückgeätzt wird.

18. Verfahren nach einem der Patentansprüche 8 bis 17, **dadurch gekennzeichnet, dass** in Schritt g) ein Rückätzen der Abdeck-Verbindungsschicht (12) und der zweiten Dotiergebiete (10) durchgeführt wird.

19. Verfahren nach einem der Patentansprüche 8 bis 18, **dadurch gekennzeichnet, dass** in Schritt g) ein silizierfähiges Material abgeschieden,
eine Silizid-Umwandlung einer Oberfläche der Abdeck-Verbindungsschicht (12) und der zweiten Dotiergebiete (10) unter Verwendung des silizierfähigen Materials durchgeführt, und das nicht umgewandelte silizierfähige Material wieder entfernt wird.

20. Verfahren nach einem der Patentansprüche 8 bis 19, **dadurch gekennzeichnet, dass** in Schritt a) für das Substrat ein Si-Halbleitermaterial; und
in den Schritten c) und f) für die vergrabene Bitleitung (SLx, 7) und die Abdeck-Verbindungsschicht (12) Polysilizium vom zum Leitungstyp (n) der zweiten Dotiergebiete (10) entgegengesetzten Leitungstyp (p) verwendet wird.

## Claims

1. Bit line structure having
a buried bit line (SLx) which, for connection of a multiplicity of second doping regions (S; 10), is formed inside a substrate (1, 2, 3), in such a manner that
a trench (T) in the substrate (1, 2, 3);
a trench insulation layer (6) at a trench surface of the trench (T);
the buried bit line (SLx, 7) in a lower region of the trench (T) on the trench insulation layer (6);
a covering insulation layer (8, 8A, 9) on the buried bit line (SLx) in a first, upper partial region of the trench (T);
a multiplicity of covering connecting layers (12) on the buried bit line (SLx) in a second upper partial region of the trench (T); and
a multiplicity of terminal layers (13) in the region of the substrate surface are formed, the multiplicity of covering connecting layers (12) being electrically connected via the terminal layers (13) to the multiplicity of second doping regions (S, 10),
**characterized in that**
a surface bit line (DLx) is formed for connection of a multiplicity of first doping regions (D) above a substrate surface.

2. Bit line structure according to Patent Claim 1, **characterized in that** the covering insulation layer (8, 9) forms a shallow trench isolation.

3. Bit line structure according to Patent Claim 1 or 2, **characterized in that** the substrate (1, 2, 3) includes crystalline silicon, the multiplicity of covering connecting layers (12) include highly doped polysilicon and the multiplicity of terminal layers (13) include a silicide.

4. Bit line structure according to one of Patent Claims 1 to 3, **characterized in that** the multiplicity of covering connecting layers (12) are also in direct contact with the substrate (3).

5. Bit line structure according to one of Patent Claims 1 to 4, **characterized in that** the multiplicity of covering connecting layers (12) have a conduction type (n) which is the same as the conduction type (n) of the second doping regions (S).

6. Bit line structure according to one of Patent Claims 1 to 4, **characterized in that** the multiplicity of covering connecting layers (12) have an opposite conduction type (p) from the conduction type (n) of the second doping regions (S).

7. Bit line structure according to one of Patent Claims 1 to 6, **characterized in that** the substrate (1, 2, 3) has a multiple well structure.

8. Method for fabricating a bit line structure, comprising the steps of:
a) forming a trench (T) in a substrate (1, 2, 3);
b) forming a trench insulation layer (6) at a trench surface of the trench (T);
c) forming an electrically conducting filling layer (7) on the trench insulation layer (6) of the trench (T) in order to realize a buried bit line (SLx);
d) forming a covering insulation layer (8, 9, 8A) in a first upper partial region of the trench (T);
e) forming first and second doping regions (10) at the surface of the substrate (3);
f) forming a multiplicity of covering connecting layers (12) on the filling layer (7) in a second upper partial region of the trench (T) in partial regions of the covering insulation layer; and
g) forming a multiplicity of self-aligning terminal layers (13) for electrically connecting the multiplicity of covering connecting layers (12) to the second doping regions (10, S); **characterized by** the further steps of;
h) forming an intermediate insulation layer (14) at the surface of the substrate;
i) forming an electrically conducting layer (15) as surface bit line (DLx); and
j) forming a multiplicity of contacts (DC) for electrically connecting the surface bit line (DLx) to the first doping regions (D).

9. Method according to Patent Claim 8, **characterized in that** in step a) a substrate with a multiple well structure and the trench (T) is formed into a second well (2).

10. Method according to Patent Claim 8 or 9, **characterized in that** in step b) a thermal oxidation is formed for the purpose of forming a liner oxide as trench insulation layer (6).

11. Method according to one of Patent Claims 8 to 10, **characterized in that** in step c) a highly doped polycrystalline semiconductor material is deposited as filler layer (7).

12. Method according to one of Patent Claims 8 to 11, **characterized in that** in step d) the filling layer (7) is etched back in an upper region of the trench (T).

13. Method according to Patent Claim 12, **characterized in that** in step d) a first covering partial layer (8) is formed by means of thermal oxidation at the surface of the filling layer (7) which has been etched back, and a second covering partial layer (9) for filling the trench (T) is formed by means of a TEOS deposition process.

14. Method according to one of Patent Claims 8 to 13, **characterized in that** in step f) a multiplicity of partial regions of the covering insulation layer (8, 9) and of the trench insulation layer (6) are removed in the upper region of the trench and in situ-doped semiconductor material is deposited and etched back in order to form the covering connecting layers (12).

15. Method according to Patent Claim 12, **characterized in that** in step d) a covering sacrificial layer (8A) is formed at the surface of the trench insulation layer (6) by means of a spacer method, and a second covering partial layer (9) is formed by means of a TEOS deposition process in order to fill the trench.

16. Method according to Patent Claim 15, **characterized in that** in step f) a multiplicity of partial regions of the covering sacrificial layer (8A) are removed in the second upper partial region of the trench (T), and in situ-doped semiconductor material is deposited and etched back in order to form the covering connecting layer (12).

17. Method according to Patent Claim 15, **characterized in that** in step f) a multiplicity of partial regions of the covering sacrificial layer (8A) of the trench insulation layer (6) and of the second covering partial layer (9) are removed in the second upper partial region of the trench (T), and in situ-doped semiconductor material is deposited and etched back in order to form the covering connecting layer (12).

18. Method according to one of Patent Claims 8 to 17, **characterized in that** in step g) the covering connecting layer (12) and the second doping regions (10) are etched back.

19. Method according to one of Patent Claims 8 to 18, **characterized in that** in step g) a silicidable material is deposited, a surface of the covering connecting layer (12) and of the second doping regions (10) are silicide converted using the silicidable material, and the unconverted silicidable material is removed again.

20. Method according to one of Patent Claims 8 to 19, **characterized in that** in step a) a Si semiconductor material is used for the substrate; and in steps c) and f) polysilicon of the opposite conduction type (p) to the conduction type (n) of the second doping regions (10) is used for the buried bit line (SLx, 7) and the covering connecting layer (12).

## Revendications

1. Structure de ligne de bits comprenant
une ligne (SLx) de bits enterrée, qui est constituée pour le raccordement d'une pluralité de deuxièmes zones (S, 10) de dopage au sein d'un substrat (1, 2, 3), de manière à former un sillon (T) dans le substrat (1, 2, 3) ;
une couche (6) d'isolation du sillon sur une surface du sillon (T) ;
la ligne (SLx) de bits enterrée dans une partie inférieure du sillon (T) sur la couche (6) d'isolation du sillon ;
une couche (8, 8A, 9) d'isolation de recouvrement sur la ligne (SLx) de bits enterrée dans une première sous-partie supérieure du sillon (T) ;
une pluralité de couches (12) de liaison de recouvrement sur la ligne (SLx) de bits enterrée dans une deuxième sous-partie supérieure du sillon (T) ; et
une pluralité de couches (13) de connexion dans la partie de la surface du substrat, la pluralité de couches (12) de liaison de recouvrement étant reliée électriquement à la pluralité de deuxièmes zones (S, 10) de dopage par les couches (13) de connexion,
**caractérisée en ce que**
une ligne (DLx) de bits de surface est formée au dessus d'une surface du substrat pour la connexion d'une pluralité de premières zones (D) de dopage.

2. Structure de ligne de bits suivant la revendication 1, **caractérisée en ce que** la couche (8, 9) d'isolation de recouvrement constitue une isolation plate du sillon.

3. Structure de ligne de bits suivant la revendication 1 ou 2, **caractérisée en ce que** le substrat (1, 2, 3) comporte du silicium cristallin, la pluralité de couches (12) de liaison de recouvrement du polysilicium très dopé et la pluralité de couches (13) de connexion un siliciure.

4. Structure de ligne de bits suivant l'une des revendications 1 à 3, **caractérisée en ce que** la pluralité de couches (12) de liaison de recouvrement touche en outre directement le substrat (3).

5. Structure de ligne de bits suivant l'une des revendications 1 à 4, **caractérisée en ce que** la pluralité de couches (12) de liaison de recouvrement comporte un type (n) de conductivité identique au type (n) de conductivité des deuxièmes zones (S) de dopage.

6. Structure de ligne de bits suivant l'une des revendications 1 à 4, **caractérisée en ce que** la pluralité de couches (12) de liaison de recouvrement a un type (p) de conductivité opposé au type (n) de conductivité des deuxièmes zones (S) de dopage.

7. Structure de ligne de bits suivant l'une des revendications 1 à 6, **caractérisée en ce que** le substrat (1, 2, 3) comporte une structure en caisson multiple.

8. Procédé de production d'une structure de ligne de bits comprenant les stades dans lesquels :
a) on forme un sillon (T) dans un substrat (1, 2, 3) ;
b) on forme une couche (6) d'isolation sur une surface du sillon (T) :
c) on forme une couche (7) de remplissage conductrice de l'électricité sur la couche (6) d'isolation du sillon (T) pour réaliser une ligne (SLx) de bits enterrée ;
d) on forme une couche (8, 9, 8A) d'isolation de recouvrement dans une première sous-partie supérieure du sillon (T) ;
e) on forme des premières et deuxièmes zones (10) de dopage à la surface du substrat (3) ;
f) on forme une pluralité de couches (12) de liaison de recouvrement sur la couche (7) de remplissage dans une deuxième sous-partie supérieure du sillon (T) dans des sous-parties de la couche d'isolation de recouvrement ; et
g) on forme une pluralité de couches (13) de connexion à auto alignement pour relier électriquement la pluralité de couches (12) de liaison de recouvrement aux deuxièmes zones (10, S) de dopage, **caractérisé par** les autres stades dans lesquels :
h) on forme une couche (14) intermédiaire isolante à la surface du substrat ;
i) on forme une couche (15) conductrice de l'électricité comme ligne (DLx) de bits de surface ; et
j) on forme une pluralité de contacts (DC) pour la liaison électrique de la ligne (DLx) de bits de surface avec les premières zones (D) de dopage.

9. Procédé suivant la revendication 8, **caractérisé en ce que** dans le stade a) on forme un substrat ayant une structure en caisson multiple et le sillon (T) jusque dans un deuxième caisson (2).

10. Procédé suivant la revendication 8 ou 9, **caractérisé en ce que** dans le stade b) on effectue une oxydation thermique pour former un oxyde liner comme couche (6) d'isolant du sillon.

11. Procédé suivant l'une des revendications 8 à 10, **caractérisé en ce qu'**au stade c) on dépose un matériau semi-conducteur polycristallin très dopé comme couche (7) de remplissage.

12. Procédé suivant l'une des revendications 8 à 11, **caractérisé en ce qu'**au stade d) on attaque en retrait la couche (7) de remplissage dans une partie supérieure du sillon (T).

13. Procédé suivant la revendication 12, **caractérisé en ce qu'**au stade d) on forme, au moyen d'une oxydation thermique, une première sous-couche (8) de recouvrement sur la surface de la couche (7) de remplissage attaquée en retrait et, au moyen d'un procédé de dépôt TEOS, une deuxième sous-couche (9) de recouvrement pour remplir le sillon (T).

14. Procédé suivant l'une des revendications 8 à 13, **caractérisé en ce qu'**au stade f) on élimine dans la partie supérieure du sillon une pluralité de sous-parties de la couche (8, 9) d'isolation de recouvrement et de la couche (6) d'isolation du sillon et on dépose et on attaque en retour du matériau semi-conducteur dopé in situ pour former les couches (12) de liaison de recouvrement.

15. Procédé suivant la revendication 12, **caractérisé en ce qu'**au stade d) on forme, au moyen d'un procédé à espaceur, une couche (8A) sacrificielle de recouvrement à la surface de la couche (6) d'isolation du sillon et, au moyen d'un procédé de dépôt TEOS, une sous-couche (9) de recouvrement pour remplir le sillon.

16. Procédé suivant la revendication 15, **caractérisé en ce qu'**au stade f) on élimine dans la deuxième sous-partie supérieure du sillon (T) une pluralité de sous-parties de couche (8A) sacrificielle de recouvrement et on dépose et attaque en retrait du matériau semi-conducteur dopé in situ pour former la couche (12) de liaison de recouvrement.

17. Procédé suivant la revendication 15, **caractérisé en ce qu'**au stade f) on élimine dans la deuxième sous-partie supérieure du sillon (T) une pluralité de sous-parties de la couche (8A) sacrificielle de recouvrement de la couche (6) d'isolation du sillon et de la deuxième sous-couche (9) de recouvrement ; et on dépose et attaque en retrait du matériau semi-conducteur dopé in situ pour former la couche (12) de liaison de recouvrement.

18. Procédé suivant l'une des revendications 8 à 17, **caractérisé en ce qu'**au stade g) on effectue une attaque en retrait de la couche (12) de liaison de recouvrement et des deuxièmes zones (10) de dopage.

19. Procédé suivant l'une des revendications 8 à 18, **caractérisé en ce qu'**au stade g) on dépose un matériau apte à être silicié,
on effectue une transformation en siliciure d'une surface de la couche (12) de liaison de recouvrement et des deuxièmes zones (10) de dopage, en utilisant le matériau apte à être silicié et on élimine à nouveau le matériau apte à être silicié qui n'a pas été transformé.

20. Procédé suivant l'une des revendications 8 à 19, **caractérisé en ce qu'**au stade a) on utilise pour le substrat un matériau semi-conducteur en Si ; et
dans les stades c) et f) on utilise pour la ligne (SLx, 7) de bits enterrée et la couche (12) de liaison de recouvrement du polysilicium du type (p) de conductivité opposé au type (n) de conductivité des deuxièmes zones (10) de dopage.
